# EUROPÄISCHE PATENTSCHRIFT

(11) **EP 0 459 179 B1**
(45) Veröffentlichungstag und Bekanntmachung des Hinweises auf die Patenterteilung: **05.04.1995**
(21) Anmeldenummer: 91107340.1
(22) Anmeldetag: 06.05.1991
(51) Int. Cl.: H01L 23/66, H01L 23/498, H01L 23/64

(54) **IC-Gehäuse, bestehend aus drei beschichteten dielektrischen Platten**
IC-housing made of three coated dielectric plates
Boîtier de circuit intégré consistant en trois lames diélectriques plaquées

(30) Priorität: 28.05.1990 DE 4017156
(43) Veröffentlichungstag der Anmeldung: 04.12.1991
(73) Patentinhaber: SIEMENS AKTIENGESELLSCHAFT, 80333 München (DE)
(72) Erfinder: Lange, Friedrich, Dr.-Ing., W-8038 Gröbenzell (DE); Ressel, Rolan, Dipl.-Phys., W-8000 München 70 (DE)

(56) Entgegenhaltungen:
- EP-A- 0 199 635
- EP-A- 0 275 973
- EP-A- 0 407 107
- US-A- 4 739 448
- US-A- 4 949 163
- PATENT ABSTRACTS OF JAPAN vol. 12, no. 17 (E-574)(2864) 19 Januar 1988 ; & JP-A-62 176 153

## Beschreibung

Die Erfindung betrifft ein IC-Gehäuse gemäß dem Oberbegriff des Patentanspruches 1 wie es in EP-A-0 275 973 beschrieben ist.

Gehäuse der vorgenannten Art sind insbesondere aus Seite 1 der Literaturstelle "Multilayer Ceramic Design Manual", Tri Quint, Semiconductor, Inc. 1989, Revision 1.0, S.1-11, Appendix A, Appendix B bekannt.

In dem Buch von Reinmut K. Hoffmann "Integrierte Mikrowellenschaltungen", Springer-Verlag, Berlin, Heidelberg, New York, Tokyo, 1983 sind auf Seite 95 gekoppelte Mikrostreifenleitungen beschrieben. Es werden später anhand von Figur 1a und Figur 1b die für IC-Gehäuse wesentlichen Gesichtspunkte nochmals im einzelnen erläutert. Aus US-A- 4 739 448 ist eine Leiterplatte bekannt, bei der Signal- und Versorgungsspannungsebene jeweils zwischen Masseebenen angeordnet sind.

Ein IC-Gehäuse sollte folgende spezielle Anforderungen erfüllen, nämlich, eine Entkopplung der Signalleitungen, eine hohe Reflexionsdämpfung, auch bei hochohmig fehlangepaßten IC-Eingängen und schließlich eine gute Glättung von Belastungsspitzen der Gleichspannungsversorgungen.

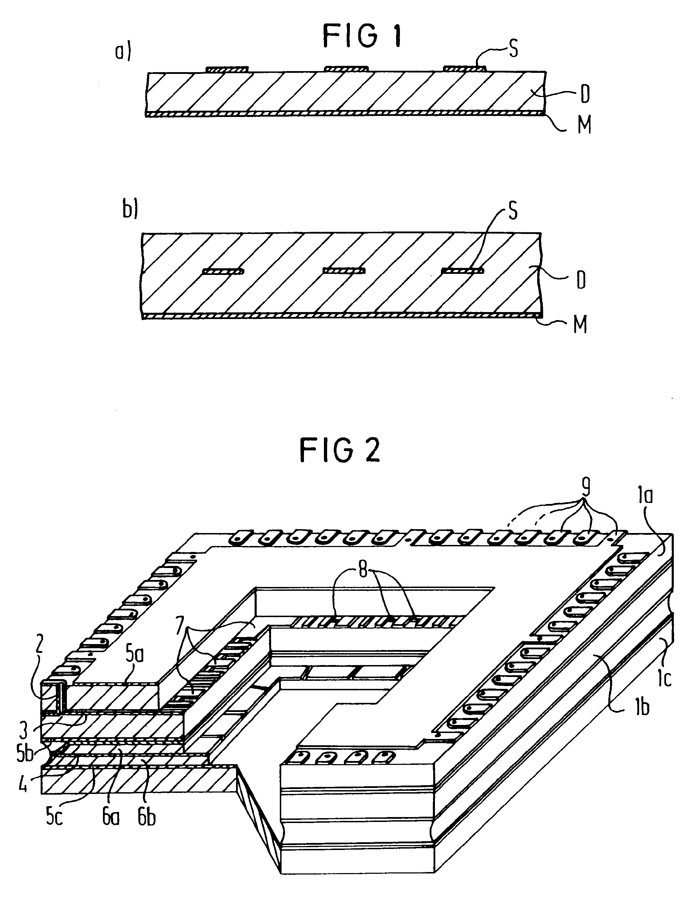

In herkömmlichen IC-Gehäusen werden als Leitungstypen (vgl. Fig. 1) im allgemeinen Mikrostreifenleitungen mit oder ohne dielektrische Abdeckung verwendet. Bei diesen Leitungstypen ist die gegenseitige Entkopplung benachbarter Leitungen für viele Anwendungen nicht hinreichend, z.B. bei großen Unterschieden im Pegelhub von Signalen (Mischanwendung ECL-, TTL-, CMOS-Pegel) und bei steilen Schaltflanken.

Zur Verbesserung der Entkopplung wird dann von den Anwendern beispielsweise nur noch jede zweite oder dritte Leitung als Signalleitung genutzt und die dazwischenliegenden Leitungen werden nach Masse geschaltet. Diese Methode ist nur mäßig wirksam.

Zur Erhöhung der Reflexionsdämpfung mußten externe Kompensationsmaßnahmen auf der Leiterplatte vorgenommen werden.

In manchen Anwendungsfällen läßt sich das Problem der Glättung von Belastungsspitzen durch Abblock-Kondensatoren lösen, die auf dem IC-Gehäuse oder extern auf der Leiterplatte untergebracht sind. Es kann jedoch auch erforderlich werden, das IC-Layout zu ändern, um störende Lasten an andere Stellen zu plazieren.

Der Erfindung liegt die Aufgabe zugrunde, ein IC-Gehäuse anzugeben, das eine Signalebene, eine Versorgungsspannungsebene und Masseebenen enthält, bei dem eine hohe Entkopplung der Signalleitungen, eine hohe Reflexionsdämpfung, auch bei hochohmig fehlangepaßten IC-Eingängen, sowie eine gute Glättung von Belastungsspitzen der Gleichspannungsversorgung gewährleistet ist.

Für ein IC-Gehäuse nach dem Oberbegriff des Patentanspruches 1 wird diese Aufgabe erfindungsgemäß nach den kennzeichnenden Merkmalen des Patentanspruches 1 gelöst.

In den Unteransprüchen sind vorteilhafte Ausgestaltungen dargestellt.

Anhand der beigefügten Ausführungsbeispiele wird die Erfindung noch im einzelnen erläutert.

Es zeigen
- Figur 1a: Mikrostreifenleitungen,
- Figur 1b: Mikrostreifenleitungen mit dielektrischer Abdeckung,
- Figur 2: ein IC-Gehäuse, und zwar ein Ausführungsbeispiel ohne Abdeckung,
- Figur 3: ein Ausführungsbeispiel für die Masseebene 5a (vgl. Figur 2), die schräge Schraffierung stellt metallisierte Flächen dar, die kleinen Kreise stellen Orte metallisierter Durchkontaktierungen in metallisierten Flächen dar,
- Figur 4: zeigt die Signalebene 3 (vgl. Figur 2), die schrägen Schraffierungen sind metallisierte Flächen,
- Figur 5: zeigt für das Ausführungsbeispiel die Versorgungsspannungsebene 4 (vgl. Figur 2), die schräge Schraffierung stellt metallisierte Flächen dar,
- Figur 6: zeigt einen Schnitt durch das IC-Gehäuse zur Darstellung vertikaler elektrischer Verbindungen, Metallisierung (enge Schraffierung), dielektrische Platten (weite Schraffierung), dielektrische Beschichtung (enge Schraffierung) und Lot (Schraffierung) sind erkennbar,
- Figur 7: zeigt an sich bekannte Triplate-Leitungen, bei denen die Streifenleiter S in einem Dielektrikum D eingebettet sind und zwei Masseebenen M vorliegen,
- Figur 8: zeigt den Koppelfaktor k = (Z_{L,even} - Z_{L,odd})/(Z_{L,even}+ Z_{L,odd}) als Funktion des Leiterabstandes s, in Figur 8a für gekoppelte Mikrostreifenleitungen in homogenem Dielektrikum, in Figur 8b für gekoppelte Triplateleitungen

Die Figur 1a zeigt eine Mikrostreifenleitung, die Figur 1b eine Mikrostreifenleitung mit dielektrischer Abdeckung nach der eingangs genannten Literaturstelle "Integrierte Mikrowellenschaltungen", Seite 95. Der Streifenleiter ist mit S, das Dielektrikum mit D und die Masse mit M bezeichnet.

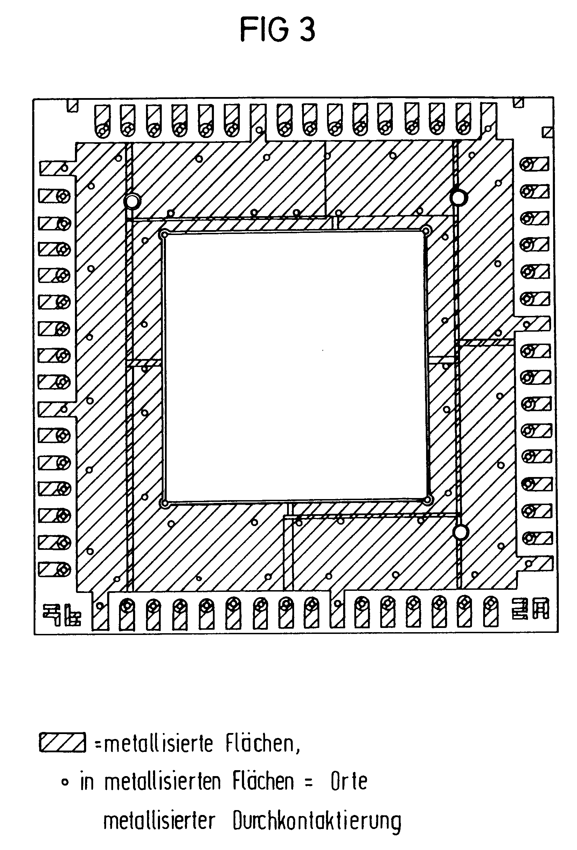

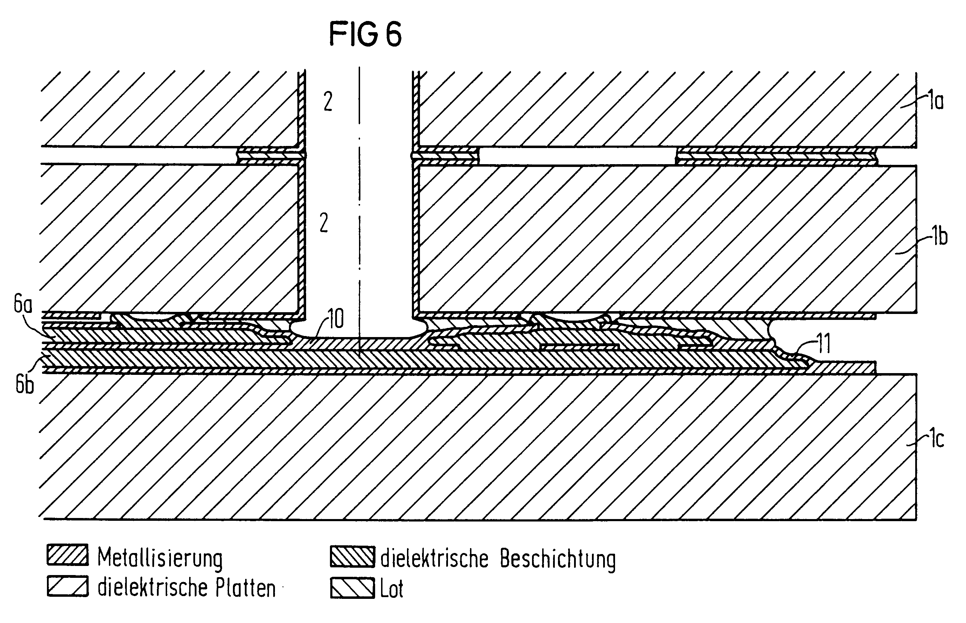

Zur Beschreibung des erfindungsgemäßen IC-Gehäuses zeigt Fig. 2 wesentliche Teile des konstruktiven Aufbaus. Die Figuren 3 bis 5 geben Beispiele für die typische Strukturierung einzelner metallisch beschichteter Ebenen und Figur 6 zeigt ein Schnittbild zur Erläuterung der vertikalen Verbindungstechnik.

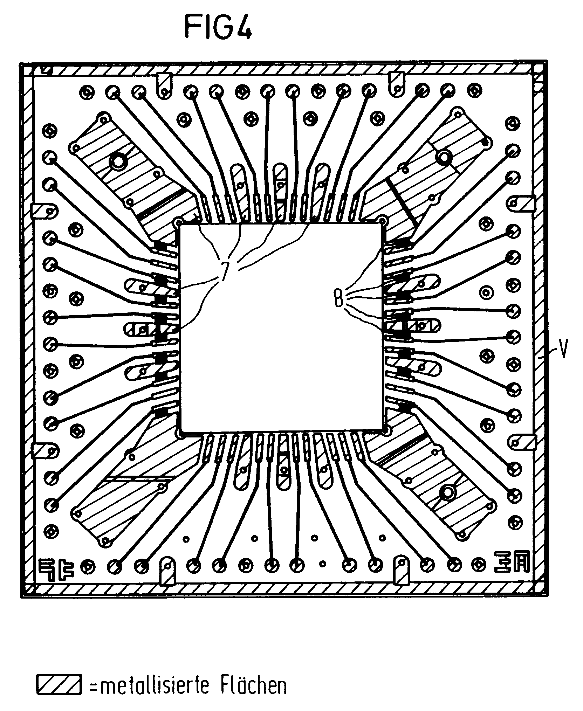

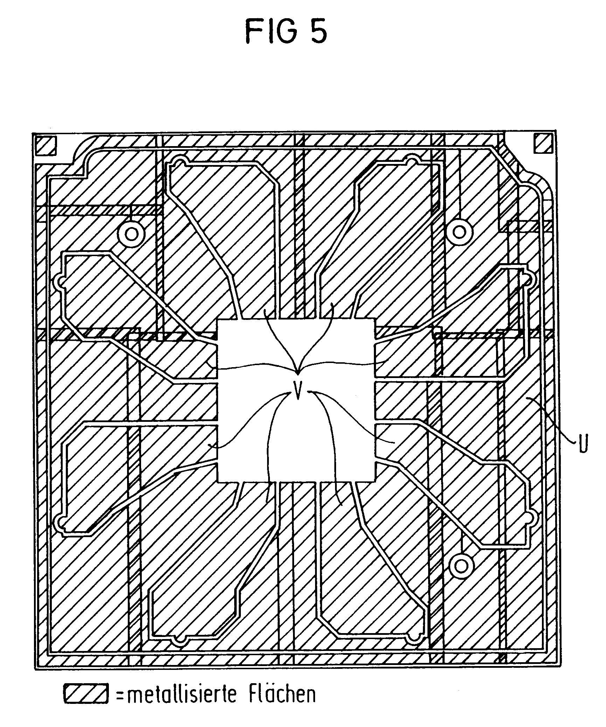

Das erfindungsgemaße IC-Gehäuse besteht aus drei beschichteten dielektrischen Platten 1a, 1b, 1c, z.B. aus Al₂O₃-Keramik, die durch Löten oder Kleben - nach außen hermetisch dicht - miteinander verbunden sind. Die elektrischen Verbindungen durch die dielektrischen Platten erfolgen über metallische Durchkontaktierungen 2. Die verschiedenen metallisierten Ebenen werden nach ihren wesentlichen Funktionen unterschieden und als Signalebene 3 (Fig. 4), Versorgungsspannungsebene 4 (Fig. 5) und Masseebene 5a (Fig. 3), 5b, 5c bezeichnet. Die Metallisierung erfolgt z.B. durch Siebdruckverfahren oder über Vakuumbeschichtung. Die Versorgungsspannungen, anliegend an den Metallisierungen U und V, sind von den Masseebenen durch dielektrische Beschichtung (z.B. dielektrischen Druck oder Vakuumbeschichtung) 6a, 6b isoliert. Die Verbindungen durch die Masseebene 5b zu den Versorgungsspannungs-Metallisierungen erfolgen über kraterförmige Strukturen 10, die Verbindung der Masseebene 5b zur Masseebene 5c durch eine heruntergezogene Metallisierung 11 (siehe Fig. 6).

In Figur 3, in Figur 4 und in Figur 5 sind metallisierte Flächen als schräge Schraffierung gezeichnet, kleine Kreise stellen Orte mit metallisierten Durchkontaktierungen in metallisierten Flächen dar.

In Figur 4 und in Figur 5 sind noch die mit U und V bezeichneten Metallisierungen erkennbar, an denen die Versorgungsspannungen anliegen.

Das IC liegt mit seiner Unterseite auf der Masseebene 5c im Gehäuse-Innenraum. Die Beschaltung der IC-Oberseite mit Signalen, Versorgungsspannungen und Masse M erfolgt über Bondverbindungen. Zum Anbringen dieser Bondverbindungen sind im IC-Gehäuse Anschlußbereiche in der Signalebene 3 und der Versorgungsspannungsebene 4 vorgesehen. Um Masseverbindungen über Bonddrähte zu ermöglichen, wird die Masse M an diversen Stellen aus der Masseebene 5b über metallische Durchkontaktierungen in den Anschlußbereich der Signalebene 3 auf Anschlüsse 7 geführt. Diese Anschlüsse 7 werden auch genutzt, um Signalleitungen über integrierte Abschlußwiderstände 8 nach Masse M zu schalten.

In Figur 6 sind wirkungsgleiche Teile mit den gleichen Bezugsziffern wie in den übrigen Figuren bezeichnet. Mit einer schrägen Schraffierung ist eine Metallisierung kenntlich gemacht, mit einer weiten Schraffierung sind dielektrische Platten kenntlich gemacht, mit einer engen Schraffierung ist eine dielektrische Beschichtung kenntlich gemacht. Und schließlich stellen schrägschraffierte Flächen Lot dar. Die Figur 6 zeigt einen Schnitt durch das IC-Gehäuse zur Darstellung vertikaler elektrischer Verbindungen. Die Versorgungsspannungsebene 4 (siehe auch Figur 5) wird durch Beschichtung mit dielektrischem Material 6a, 6b, z.B. Druck mit der Dielektrikumspaste QP445 der Firma DuPont Electronics (Permittivität εᵣ = 6 ... 8), von den zwei umgebenden Masseebenen 5b, 5c isoliert. Das vorgenannte Material ist im Handel erhältlich und in Firmenkatalogen der Firma DuPont beschrieben.

Die Außenanschlüsse 9 des IC-Gehäuses befinden sich in der oberen Masseebene 5a. Die Verbindung zur Leiterplatte kann z.B. über Metallbändchen erfolgen, die in Form einer Metallspinne gemeinsam auf das IC-Gehäuse aufgelötet werden. Das IC-Gehäuse wird durch metallische oder dielektrische Abdeckung hermetisch geschlossen. Durchkontaktierungen, die außerhalb dieser Abdeckung liegen, werden durch dielektrische Beschichtung hermetisch abgedichtet. Diese Beschichtung kann bei Verwendung einer dielektrischen Abdeckung (z.B. Keramikkappe) auch flächig über die gesamte obere Platte 1a erfolgen, wobei der Anschlußbereich für die Metallspinne freibleiben muß.

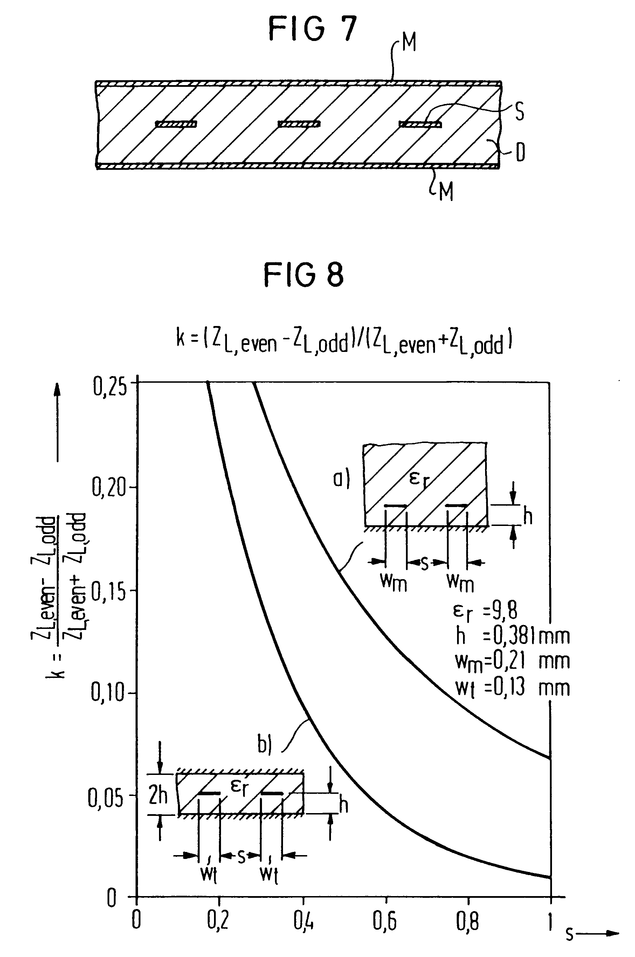

Der Aufbau an sich bekannter Triplateleitungen ist in Figur 7 nochmals zur besseren Übersicht dargestellt.

Die Streifenleiter S sind in einem Dielektrikum D eingebettet, und es liegen zwei Masseebenen M an Ober- und Unterseite des Dielektrikums D vor.

In Figur 8 ist der Koppelfaktor k gekoppelter Leitungen zwischen den Werten s = 0 und s = 1 mm als Beispiel dargestellt. Die einzelnen Zahlenwerte sind mitgezeichnet. Der Koppelfaktor k ist definiert als (Z_{L,even} - Z_{L,odd})/(Z_{L,even} + Z_{L,odd}) Die Kurve a) zeigt das Ergebnis für gekoppelte Mikrostreifenleitungen in homogenem Dielektrikum, die Kurve b) zeigt das Ergebnis für gekoppelte Triplateleitungen. Die Kurven gelten für die mitgezeichneten Werte εᵣ = 9,8 , h = 0,381 mm, wₘ = 0,21 mm und wₜ = 0,13 mm.

Die Signalleitungen werden als Triplate-Leitungen entsprechend Figur 7 ausgeführt. Die beiden Masseebenen dieses Leitungstyps werden durch regelmäßige Verbindungen über metallische Durchkontaktierungen auf gleichem Potential gehalten. Dieser Leitungstyp ermöglicht relativ hohe Entkopplung.

In einem einfachen modellhaften Vergleich hierzu stellt Figur 8 die berechneten Koppelfaktoren für gekoppelte Mikrostreifenleitungen in homogenem Dielektrikum und gekoppelte Triplate-Leitungen gegenüber. Die Leiterbreiten sind dabei jeweils so gewählt, daß die Leitungswellenwiderstände für Entkopplung, d.h. für sehr große Spaltbreite s --> ∞, 50Ω betragen, was gleichbedeutend mit s/w >> 1 ist.

Die Signalleitungen werden mit dem zur Anpassung notwendigen definierten Leitungswellenwiderstand (z.B. ---> Z_{L} = 50Ω) durch das IC-Gehäuse geführt. Signalleitungen, die zu hochohmig fehlangepaßten IC-Eingängen führen, werden durch integrierte Widerstände 8 angepaßt nach Masse geschaltet.

Die Masse wird dazu an verschiedenen Stellen über metallische Durchkontaktierungen aus der Masseebene 5b in die Signalebene 3 gezogen.

Die integrierten Widerstände 8 lassen sich z.B. durch Dickschichtdruck aufbringen. Bei Variation, der IC-Anschlüsse, die parallel einen integrierten Abschlußwiderstand benötigen, muß dann nur die Maske des Widerstandsdrucks geändert werden.

Die Versorgungsspannungsebene 4 (s. auch Figur 5) wird durch Beschichtung mit dielektrischem Material 6a, 6b, z.B. Druck mit der Dielektrikumspaste QP455 von Fa. DuPont Electronics (Permittivität εᵣ = 6 ... 8), von den zwei umgebenden Masseebenen 5b, 5c isoliert. Dadurch sind die Gleichspannungsversorgungen hoch kapazitiv und induktivitätsarm. Hochfrequente Belastungsspitzen werden dann insbesondere deshalb gut geglättet, weil auch die lokale Kapazität im direkten Bereich der Anschlüsse zum IC hin sehr hoch ist. Die Verbindungen durch die Masseebene 5b zu den Versorgungsspannungs-Metallisierungen erfolgen über kraterförmige Strukturen 10, die Verbindung der Masseebene 5b zur Masseebene 5c durch heruntergezogene Metallisierung 11, wie dies in Figur 6 erkennbar ist.

## Patentansprüche

1. IC-Gehäuse,
bestehend aus einer Abfolge von drei dielektrischen Platten (1a, 1b, 1c) und ebenen leitfähigen Strukturen (3, 5a, 5b, 5c), die als Beschichtungen der dielektrischen Platten ausgebildet sind und eine Signalebene (3) bzw. Masseebenen (5a, 5b, 5c) bilden
wobei die beiden dielektrischen Platten (1a, 1b), zwischen denen sich die Signalebene (3) befindet, auf ihren dieser Signalebene (3) abgewandten Seite Masseebenen (5a, 5b) aufweisen, so daß die in der Signalebene (3) liegenden Signalleitungen als Triplate-Leitungen ausgebildet sind,
mit einer Vorsorgungsspannungsebene (4), zwischen der und der Signalebene (3) eine der genannten Masseebenen (5b) angeordnet ist,
sowie mit in der Signalebene (3) angeordneten integrierten Widerständen (8) zum reflexionsfreien Abschluß der Signalleitungen,
**dadurch gekennzeichnet**,
daß die Versorgungsspannungsebene (4) beidseitig mit einer Beschichtung (6a, 6b) aus dielektrischem Material versehen und zwischen zwei (5b, 5c) der genannten Masseebenen angeordnet ist, wobei die Beschichtung die Versorgungsspannungsebene von den sie umgebenden Masseebenen (5b,5c) isoliert und das Material und die Dicke der Beschichtung (6a, 6b) so gewählt sind, daß sich eine zum Glätten von Belastungsspitzen der Gleichspannungsversorgung ausreichend große Kapazität pro Flächeneinheit ergibt.

2. IC-Gehäuse nach Anspruch 1,
**gekennzeichnet durch**
die Verwendung von Standard-Schichttechnologie auf Al₂O₃-Keramik in Form von festen Platten.

3. IC-Gehäuse nach Anspruch 1 oder 2,
**dadurch gekennzeichnet**,
daß elektrische Verbindungen durch dielektrische Platten (1a, 1b) über Durchkontaktierungen (2) erfolgen, die durch dielektrische Beschichtung hermetisch dicht abgedeckt sind.

4. IC-Gehäuse nach einem dem vorhergehenden Ansprüche,
**dadurch gekennzeichnet**,
daß die Versorgungsspannungsmetallisierungen (U, V) jeweils umlaufend elektrisch verbunden sind und dabei eine umlaufende Verbindung (U) in der Versorgungsspannungsebene (4) und die andere umlaufende Verbindung (V) in der Signalebene (3) liegt.

## Claims

1. IC casing comprising a sequence of three dielectric panels (1a, 1b, 1c) and flat conductive structures (3, 5a, 5b, 5c) which are constructed as coatings on the dielectric panels and form a signal plane (3) and earth planes (5a, 5b, 5c), the two dielectric panels (1a, 1b) between which the signal plane (3) is located having earth planes (5a, 5b) on their side facing away from this signal plane (3) so that the signal lines which are located in the signal plane (3) are constructed as triplate lines, having a supply voltage plane (4), between which and the signal plane (3) one of the said earth planes (5b) is arranged, and having integrated resistors (8), which are arranged in the signal plane (3) for reflection-free termination of the signal lines, characterized in that the supply voltage plane (4) is provided on both sides with a coating (6a, 6b) made of dielectric material and is arranged between the two (5b, 5c) of the said earth planes, the coating insulating the supply voltage plane from the earth planes (5b, 5c) surrounding them and the material and the thickness of the coating (6a, 6b) being selected such that it results in a sufficiently large capacitance per unit area to smooth the load spikes on the DC voltage supply.

2. IC casing according to Claim 1, characterized by the use of standard layer technology on Al₂O₃ ceramic in the form of solid panels.

3. IC casing according to Claim 1 or 2, characterized in that electrical connections are effected by means of dielectric panels (1a, 1b), via through-plated holes (2) which are covered in a hermetically sealed manner by dielectric coating.

4. IC casing according to one of the preceding claims, characterized in that the supply voltage metallizations (U, V) are in each case electrically connected circumferentially and, in this case, one circumferential connection (U) is located in the supply voltage plane (4) and the other circumferential connection (V) is located in the signal plane (3).

## Revendications

1. Boîtier de circuit intégré,
constitué par une succession de trois plaques diélectriques (1a,1b,1c) et de structures conductrices planes (3,5a,5b,5c), qui sont réalisées sous la forme de revêtements des plaques diélectriques et forment un plan (3) de transmission de signaux et des plans de masse (5a,5b,5c),
dans lequel les deux plaques diélectriques (1a,1b), entre lesquelles est situé le plan (3) de transmission des signaux, possèdent, sur leur côté tourné à l'opposé de ce plan (3) de transmission des signaux, des plans de masse (5a,5b), en sorte que les lignes de transmission de signaux, qui sont situées dans le plan (3) de transmission de signaux, sont réalisées sous la forme de lignes Triplate, et
comportant un plan (4) d'application de la tension d'alimentation, l'un desdits plans de masse (5b) étant disposé entre ce plan (4) et le plan (3) de transmission des signaux,
ainsi que des résistances intégrées (8), qui sont disposées dans le plan (3) de transmission des signaux et servent à réaliser la fermeture sans réflexion des lignes de transmission de signaux,
caractérisé par le fait
que le plan (4) d'application de la tension d'alimentation comporte, sur ses deux faces, un revêtement (6a,6b) formé d'un matériau diélectrique et est disposé entre deux (5b,5c) desdits plans de masse, le revêtement du plan d'application de la tension d'alimentation étant isolé des plans de masse (5b,5c) qui entourent ce plan, et le matériau et l'épaisseur du revêtement (6a,6b) étant choisis de telle sorte qu'on obtient, par unité de surface, une capacité suffisamment élevée pour lisser des pointes de charge de l'alimentation en tension continue.

2. Boîtier de circuit intégré suivant la revendication 1, caractérisé par l'utilisation d'une technologie standard de dépôt de couches sur une céramique en Al₂O₃, sous la forme de plaques rigides.

3. Boîtier de circuit intégré suivant la revendication 1 ou 2, caractérisé par le fait que des liaisons électriques sont établies à travers des plaques électriques (1a,1b), par l'intermédiaire de contacts traversants (2), qui sont fermés d'une manière hermétiquement étanche par un revêtement diélectrique.

4. Boîtier de circuit intégré suivant l'une des revendications précédentes, caractérisé par le fait que les métallisations (U,V) d'application de la tension d'alimentation sont reliées électriquement selon une disposition périphérique et qu'une liaison périphérique (U) est située dans le plan (4) d'application de la tension d'alimentation et que l'autre liaison périphérique (V) est située dans le plan (3) de transmission des signaux.
